# EUROPÄISCHE PATENTANMELDUNG

(11) **EP 4 304 090 A1**
(43) Veröffentlichungstag der Anmeldung: **10.01.2024**
(21) Anmeldenummer: 23177570.1
(22) Anmeldetag: 06.06.2023
(51) Int. Cl.: H03K 17/96, A47J 37/00, G06F 3/044, G06F 3/0488

(54) **ELEKTROGERÄT, VORZUGSWEISE HAUSHALTSGERÄT**

(30) Priorität: 06.07.2022 DE 102022116889
(71) Anmelder: Miele & Cie. KG, 33332 Gütersloh (DE)
(72) Erfinder: Mersch-Justus, André, 33758 Schloß Holte-Stukenbrock (DE); Kinder, Daniel, 33739 Bielefeld (DE); Kastner, Martin, 56077 Koblenz (DE)

(57) **Zusammenfassung**

Die Erfindung betrifft ein Elektrogerät (1), vorzugsweise ein Haushaltsgerät (1), mit wenigstens einem Griffelement (12), welches ausgebildet ist, zum Gebrauch des Elektrogeräts (1) von einem Benutzer mit zumindest einer Hand gegriffen zu werden, wobei das Griffelement (12) wenigstens einen taktilen Sensor (13) aufweist, welcher ausgebildet ist, ein Greifen des Griffelements (12) durch den Benutzer zu erfassen. Das Elektrogerät (1) ist dadurch gekennzeichnet, dass das Elektrogerät (1), vorzugweise eine Steuerungseinheit des Elektrogeräts (1), ausgebildet ist,
• die Art des Greifens des Griffelements (12) durch den Benutzer zu bestimmen und
• das Elektrogerät (1) in Abhängigkeit der Art des Greifens des Griffelements (12) durch den Benutzer zu betreiben oder nicht zu betreiben.

## Beschreibung

Die Erfindung betrifft ein Elektrogerät, vorzugsweise ein Haushaltsgerät, sowie ein Verfahren zum Betreiben eines Elektrogeräts, vorzugsweise eines Haushaltsgeräts.

Bei vielen verschiedenen Vorrichtungen bzw. Geräten ist es bekannt, dass das Gerät von einer Person als Benutzer mittels eines Handhabungselements gehandhabt, geführt bzw. bedient werden kann. Derartige Handhabungselemente könnten beispielsweise Handgriffe sein, welche von der Person mit einer Hand oder mit beiden Händen zu greifen sind, um eine Handhabung bzw. Bedienung durchzuführen. Zu diesen Vorrichtungen bzw. Geräten gehören die Elektrogeräte allgemein, welche auch die Haushaltsgeräte und diese die Küchengeräte mit einschließen.

So kann beispielsweise ein Griff eines Staubsaugers, insbesondere eines Handstaubsaugers, von einer Hand einer Person gegriffen und gehalten werden, um den Staubsauger über den Boden zu führen. Ebenso kann ein Wasserkocher an einem Griff von einer Person gegriffen und gehalten werden, um den Wasserkocher zu bewegen bzw. zu führen. Küchengeräte wie Backöfen, Mikrowellen, Dampfgarer sowie Kombigeräte hiervon ebenso wie Küchenschränke, Gefrierschränke, Weinkühlschränke und dergleichen können an einem, üblicherweise vergleichbar langen, Griff gegriffen werden, um dessen Tür, Klappe und dergleichen schwenken und hierdurch öffnen und schließen zu können. Genauer gesagt wird dies bei Backöfen und dergleichen beispielsweise über das Umgreifen einer Leiste als Griff ermöglicht. Bei Kühlschränken kann das Greifen in eine Griffmulde erfolgen. Bei Staubsaugern dient üblicherweise ein abgerundeter Griff dazu, diesen festzuhalten. Derartige Griffe an Haushaltsgeräten zum Zweck des Öffnens und Schließens bzw. Haltens sind von verschiedenen Herstellern bekannt. Neben designtechnischen oder ergonomischen Unterschieden liegen technologisch jedoch keine Unterschiede vor. Üblicherweise weisen derartige Griffe somit keinerlei weitere Funktionen auf.

Es sind sog. Totmannschalter oder Totmanngriffe bekannt, welche der Arbeitssicherheit bzw. der Bediensicherheit von Maschinen und Geräten dienen. Derartige Maschinen und Geräte lassen sich nur dann betreiben, solange die Person mit wenigstens einer Hand den Schalter drückt bzw. den Griff umgreift. Lässt die Person den Totmannschalter bzw. Totmanngriff los, so wird dies von einer Steuerung erkannt und in Reaktion hierauf die Maschine oder das Gerät gestoppt. Zum Einschalten insbesondere von Geräten ist üblicherweise eine zusätzliche Bedienhandlung erforderlich, um den Totmannschalter bzw. Totmanngriff zu entriegeln. Hierdurch kann verhindert werden, dass das Gerät versehentlich durch bloßes Aufnehmen oder durch Herunterfallen eingeschaltet wird.

Bei Elektrowerkzeugen ist auch die Erkennung von Händen einer Person bekannt. Aus sicherheitstechnischen Gründen kann es erforderlich sein, dass gewisse Elektrowerkzeuge an zwei verschiedenen Stellen mit beiden Händen bedient werden müssen, um Verletzungen durch eine falsche Bedienung zu vermeiden. Über Sensorelemente kann erkannt werden, ob die Hände der Person die jeweiligen Griffstellen umfassen, um zu vermeiden, dass der Benutzer über Umwege, z.B. durch das Festbinden der Griffstellen durch Kabelbinder oder Bänder, das Gerät mit nur einer Hand bedient. Die Sensorik kann dafür unterscheiden, ob eine Hand oder etwas anderes die Griffstellen umfasst.

Des Weiteren ist im Bereich der Backöfen bekannt, dass Geräte im Rahmen von Reinigungsfunktionen automatisch die Klappe verriegeln, um potenzielle Gefahren durch Hitze für den Benutzer zu vermeiden. Bei gewissen Reinigungsprogrammen wie z.B. Pyrolyse werden Backöfen auf besonders heiße Temperaturen von über 500 Grad Celsius aufgeheizt. Damit hierdurch keine Gefahr für den Benutzer entstehen kann, verriegeln sich die Backofentüren mechanisch, sodass sie während der Reinigung nicht geöffnet werden können.

Die DE 10 2018 001 305 A1 beschreibt eine Vorrichtung sowie ein Verfahren zum Betrieb einer ebensolchen Vorrichtung. Die Vorrichtung umfasst eine elektrische Einschaltlogik, eine manuelle Handhabungsschnittstelle, wobei die Vorrichtung zum Gebrauch von einem Benutzer mit zumindest einer Hand an der Handhabungsschnittstelle gegriffen werden muss, ein Sensorsystem mit zumindest einem an einer Oberfläche der Handhabungsschnittstelle angeordneten flächigen Kraftsensor mit einer Vielzahl arrayförmig angeordneter Kraftsensorelementen zur flächigen Erfassung lokaler Krafteinträge für mehrere unterschiedliche Oberflächenbereiche der Handhabungsschnittstelle und bzw. oder mit mehreren an der Oberfläche der Handhabungsschnittstelle angeordneten Kraftsensoren zur Erfassung lokaler Krafteinträge für jeweils nur einen zugeordneten Oberflächenbereich der Handhabungsschnittstelle, wobei die Einschaltlogik derart ausgeführt und eingerichtet ist, dass sie ein operationelles Inbetriebnehmen der Vorrichtung nur dann erlaubt, wenn die für jeden der Oberflächenbereiche erfassten Beträge der Krafteinträge größer sind als für die jeweiligen Oberflächenbereiche jeweils individuell vorgegebene Grenzwerte.

Der Erfindung stellt sich somit das Problem, die Möglichkeiten zur Handhabung bzw. Bedienung von Elektrogeräten und insbesondere von Haushaltsgeräten mittels ihrer Griffelemente und dergleichen zu verbessern bzw. zu erweitern. Dies soll möglichst einfach, kostengünstig, bauraumsparend, vielfältig und bzw. oder intuitiv bedienbar erfolgen können. Zumindest soll eine Alternative zu den bekannten Möglichkeiten geschaffen werden.

Erfindungsgemäß wird dieses Problem durch ein Elektrogerät sowie durch ein Verfahren mit den Merkmalen der unabhängigen Ansprüche gelöst. Vorteilhafte Ausgestaltungen und Weiterbildungen der Erfindung ergeben sich aus den nachfolgenden abhängigen Ansprüchen.

Die vorliegende Erfindung betrifft somit ein Elektrogerät, vorzugsweise ein Haushaltsgerät, mit wenigstens einem Griffelement, welches ausgebildet ist, zum Gebrauch des Elektrogeräts von einem Benutzer mit zumindest einer Hand gegriffen zu werden. Das Elektrogerät kann ein beliebiges Gerät sein, welches zum einen elektrisch betrieben und zum anderen zum bestimmungsgemäßen Gebrauch von einer Person als Nutzer, als Benutzer bzw. als Bediener mit wenigstens einer Hand gehalten bzw. gegriffen wird. Derartige Elektrogeräte können Handwerksgeräte sowie Haushaltsgeräte inklusive Küchengeräte sein.

Das Griffelement weist wenigstens einen taktilen Sensor auf, welcher ausgebildet ist, ein Greifen des Griffelements durch den Benutzer zu erfassen. Der taktile Sensor kann hierzu wenigstens ein flächiges Sensorelement aufweisen, welches eine flächige Krafteinwirkung sensorisch erfassen kann. Der taktile Sensor kann jedoch auch eine Vielzahl von Sensorelementen aufweisen, welche punktuell eine Krafteinwirkung sensorisch erfassen können. In jedem Fall können hierdurch die entsprechenden Kraftinformationen bzw. Druckinformationen gewonnen werden.

Das Elektrogerät ist dadurch gekennzeichnet, dass das Elektrogerät, vorzugweise eine Steuerungseinheit des Elektrogeräts, ausgebildet ist,
- die Art des Greifens des Griffelements durch den Benutzer zu bestimmen und
- das Elektrogerät in Abhängigkeit der Art des Greifens des Griffelements durch den Benutzer zu betreiben oder nicht zu betreiben.

Auf diese Art und Weise kann erfindungsgemäß eine zusätzliche Funktion in das Greifen des Griffelements durch den Benutzer eingebracht werden, indem auf diese Art und Weise eine Interaktion mit dem Elektrogerät stattfinden kann. Dies kann beispielsweise der personenspezifischen Bedienung des Elektrogerätes dienen, dem der Bediener aufgrund der Art des Greifens erkannt werden kann. Zusätzlich oder alternativ kann die Art des Greifens als Bedieneingabe verwendet werden, um beispielsweise in Abhängigkeit der Stärke des Greifens beispielsweise eine Leistungseinstellung eines Staubsaugers bzw. eine Temperatureinstellung eines Backofens vorzunehmen. Zusätzlich oder alternativ kann die Art des Greifens auch als Sicherheitsfunktion verwendet werden, um beispielsweise die Leistung eines Bohrhammers an die Stärke des Greifens der Person anzupassen und somit bei zunehmender Erschöpfung der Person die Leistung zu reduzieren.

Dies kann die Möglichkeiten bzw. den Komfort der Bedienung und bzw. oder die Sicherheit der Benutzung erhöhen. Hiervon ist auch umfasst, dass ein Betreiben des Elektrogeräts in Abhängigkeit der Art des Greifens zumindest hinsichtlich einzelner Funktionen sowie insgesamt unterbleiben kann
Gemäß einem Aspekt der Erfindung umfasst die Art des Greifens des Griffelements durch den Benutzer:
- eine Position des Greifens des Griffelements durch den Benutzer entlang des taktilen Sensors in wenigstens einer Richtung, vorzugsweise in wenigstens zwei Richtungen,
- eine Bewegung des Greifens des Griffelements durch den Benutzer entlang des taktilen Sensors in wenigstens einer Richtung, vorzugsweise in zwei Richtungen,
- eine Größe der Fläche des Greifens des Griffelements durch den Benutzer entlang des taktilen Sensors in wenigstens einer Richtung, vorzugsweise in zwei Richtungen,
- eine Kontur der Fläche des Greifens des Griffelements durch den Benutzer entlang des taktilen Sensors in wenigstens einer Richtung, vorzugsweise in zwei Richtungen,
- eine Kraft des Greifens des Griffelements durch den Benutzer senkrecht zum taktilen Sensor und bzw. oder
- eine Kraftänderung des Greifens des Griffelements durch den Benutzer senkrecht zum taktilen Sensor.

Hierdurch können unterschiedliche Möglichkeiten geschaffen werden, die Art des Greifens zu bewerten bzw. zu bestimmen.

Gemäß einem weiteren Aspekt der Erfindung ist das Elektrogerät, vorzugweise dessen Steuerungseinheit, ausgebildet, den Benutzer aufgrund der bestimmten Art seines Greifens des Griffelements zu erkennen, wobei das Elektrogerät, vorzugweise dessen Steuerungseinheit, ferner ausgebildet ist, wenigstens eine Funktion in Abhängigkeit des erkannten Benutzers auszuführen oder nicht auszuführen. Hierdurch kann ein Erkennen des Benutzers sowie ein personenspezifischer Betrieb des Elektrogeräts erfolgen, wie eingangs bereits erwähnt.

Gemäß einem weiteren Aspekt der Erfindung ist das Elektrogerät, vorzugweise dessen Steuerungseinheit, ausgebildet, eine Stimmung des Benutzers aufgrund der Art seines Greifens des Griffelements zu erkennen, wobei das Elektrogerät, vorzugweise dessen Steuerungseinheit, ferner ausgebildet ist, wenigstens eine Funktion in Abhängigkeit der erkannten Stimmung des Benutzers auszuführen oder nicht auszuführen. Diesem Aspekt der vorliegenden Erfindung liegt die Erkenntnis zugrunde, dass sich die Stimmung bzw. der Gemütszustand einer Person auch in der Art und Weise widerspiegeln können, wie das Elektrogerät von der Person mit der Hand gegriffen wird. Entsprechend kann auch in Reaktion hierauf die Betriebsweise des Elektrogeräts angepasst werden. Ein Sensor dieser Art kann bei entsprechender Genauigkeit und zugrundeliegendem Datenbestand auch genutzt werden, um Krankheitsbilder oder Zustände des Nutzers (unterstützend) zu erkennen: bpsw. von allgemeinem Stress (schwitzige Hände) bis hin zu zittrigen Greif-Vorgängen oder ungewohnten Verkrampfungen, etc. Auch in Reaktion hierauf kann die Betriebsweise des Elektrogeräts angepasst werden.

Grundsätzlich können 4 Dimensionen gemäß der Erfindung berücksichtigt werden:
- Zwei am Griff (örtlich, wo greift der Nutzer),
- Der Druck, mit dem der Benutzer auf den Griff einwirkt,
- Die zeitliche Dimension der Signal-Verteilung bzw. der zeitliche Verlauf der vorstehend genannten Parameter.

Gemäß einem weiteren Aspekt der Erfindung ist das Elektrogerät, vorzugweise dessen Steuerungseinheit, ausgebildet, wenigstens eine Funktion in Abhängigkeit der bestimmten Art seines Greifens des Griffelements, vorzugsweise in Abhängigkeit des erkannten Benutzers, freizugeben oder zu sperren. Beispielsweise kann auf diese Art und Weise ein vergleichsweise schwacher bzw. räumlich begrenzter Griff eines Kindes erkannt und beispielsweise mittels eines betätigbaren Riegels die Klappe eines Backofens verriegelt werden, um zu verhindern, dass das Kind in den vermeintlich heißen Innenraum des Backofens greifen kann. Dies kann die Sicherheit der Bedienung bzw. der Nutzung des Elektrogeräts erhöhen.

Gemäß einem weiteren Aspekt der Erfindung ist der taktile Sensor flächig auf dem Griffelement ausgebildet. Dies kann eine flächig durchgängige sensorische Erfassung des Griffs bzw. des Greifens des Benutzers ermöglichen.

Gemäß einem weiteren Aspekt der Erfindung weist der taktile Sensor eine Mehrzahl von flächig angeordneten einzelnen Sensorelementen auf. Dies kann die Umsetzung vereinfachen bzw. die Kosten geringhalten.

Gemäß einem weiteren Aspekt der Erfindung ist der taktile Sensor resistiv und/oder kapazitiv erfassend ausgebildet. Mit anderen Worten kann die sensorische Erfassung mittels einer Veränderung des elektrischen Widerstands oder der Kapazität des taktilen Sensors erfolgen. Dies kann eine vergleichsweise einfache Umsetzung ermöglichen.

Gemäß einem weiteren Aspekt der Erfindung ist der taktile Sensor flexibel, vorzugsweise mittels eines flexiblen Trägers, ausgebildet. Dies kann die Anpassung bzw. Anbringung des taktilen Sensors an unterschiedliche Formen bzw. Konturen von Griffen ermöglichen bzw. vereinfachen.

Die vorliegende Erfindung betrifft auch ein Verfahren zum Betreiben eines Elektrogeräts, vorzugsweise eines Haushaltsgeräts, wobei das Elektrogerät wenigstens ein Griffelement aufweist, welches ausgebildet ist, zum Gebrauch des Elektrogeräts von einem Benutzer mit zumindest einer Hand gegriffen zu werden, wobei das Griffelement wenigstens einen taktilen Sensor aufweist, welcher ausgebildet ist, ein Greifen des Griffelements durch den Benutzer zu erfassen, mit wenigstens den Schritten:
- Erfassen des Greifens des Griffelements durch den Benutzer,
- Bestimmen der Art des Greifens des Griffelements durch den Benutzer und
- Betreiben des Elektrogeräts in Abhängigkeit der Art des Greifens des Griffelements durch den Benutzer oder nicht.

Hierdurch kann ein Verfahren geschaffen werden, um die entsprechenden zuvor beschriebenen Aspekte eines erfindungsgemäßen Elektrogeräts umsetzen und nutzen zu können.

Mit anderen Worten liegt der vorliegenden Erfindung die Erkenntnis zugrunde, dass Griffe an Haushaltsgeräten keinen besonderen Nutzen aufweisen. Sie sind notwendig, um Türen, Klappen und dergleichen von Geräten zu öffnen und zu schließen bzw. um Geräte in der Hand halten zu können, aber erfüllen darüber hinaus keinen Mehrwert für den Nutzer.

Ferner muss jeder Nutzung üblicherweise viele Funktionen und Nutzungsmöglichkeiten wie Programme, Stufen etc. von Haushaltsgeräten für sich manuell einstellen, bzw. das Gerät erkennt nicht von selbst, welche Person das Gerät gerade nutzen möchte. Das erschwert eine intuitive Bedienung und personalisierte Nutzung von sonst technologisch hochwertigen Geräten. Eine Personalisierung ist momentan nicht direkt über das Gerät möglich, sondern lediglich über Vernetzung mit Internet-Anwendungen (Apps mit persönlicher ID), über Kl-Systeme oder auch Kameraanwendungen. Nutzer der Geräte werden zudem nicht automatisch erkannt.

Daher sollen Messwerte vorzugsweise verschiedene Aussagen über Kundenverhalten erzeugen und insbesondere eine dauerhafte Optimierung von weiteren Produkten und bzw. oder eine prädiktive Wartung ermöglichen können. Vorzugsweise soll das Erzeugen von Daten die Erstellung von Nutzerprofilen und Gamification-Ansätzen ermöglichen können. Vorzugsweise sollen alternativ oder zusätzlich dadurch, dass der Griff des Menschen sehr individuell ist, Personen alleine darüber erkannt werden und vorzugsweise personalisierte Funktionsvorschläge vom Gerät getätigt werden können, beispielsweise oft genutzte Backofenprogramme einer Person, Rezeptvorschläge, keine Funktionsnutzung bei Kindern etc. Zusätzlich oder alternativ soll die Sensorik über die Art, wie der Nutzer greift, erkennen können, in welcher Stimmungslage sich der Nutzer befindet (Mood-Detection).

Erfindungsgemäß können somit erfindungsgemäß die oben genannten Verbesserungen zumindest teilweise dadurch erreicht werden, dass eine taktile Sensorik in Griffen von Geräten wie beispielsweise in Backöfen, Kühlschränken, Staubsaugern und dergleichen verbaut wird. Es können insbesondere flexible sowie resistive oder kapazitive Sensoren verwendet werden, deren Leistung nicht durch Dehnung und Biegung beeinflusst wird. Dadurch kann der Handgriff wie eine "zweite Haut" reagieren und erkennen:
- Veränderungen der Fingerpositionen,
- Größe der Hand,
- Art des Greifens und damit Erkennen des Nutzers und dessen Stimmung,
- ausgeübter Druck von der umfassenden Hand auf den Handgriff und bzw. oder
- Konturen und bzw. oder Art des Greifens der Hand,
sodass Nutzer individuell erkannt werden können. Ein wesentlicher Aspekt der vorliegenden Erfindung kann somit im Zusammenhang zwischen dem taktilen Sensor und der daraus resultierenden Steuerung des Geräts gesehen werden.

Da die taktile Sensorik sehr feinfühlig sein kann, kann die taktile Sensorik unterschiedliche Arten des Greifens erkennen und somit zwischen Personen unterscheiden, da der Griff bei Menschen sehr individuell ist. Je nach Person können geeignete Funktionsvorschläge getätigt und bzw. oder auch Funktionen eingeschränkt werden, beispielsweise für Kinder.

Darüber hinaus kann diese Feinfühligkeit der taktilen Sensorik es ermöglichen, dass Emotionen bzw. Stimmungen des Nutzers erkannt werden können, da Menschen üblicherweise bei unterschiedlichen Emotionslagen wie beispielsweise Wut, Nervosität, Freude und dergleichen unterschiedlich zugreifen. Die entsprechende Sensitivität der taktilen Sensorik kann in diesem Zusammenhängen Potenziale zur Generierung von aussagekräftigen Daten bieten, wie z.B. Daten zur Kraft der Person, welche Druckpunkte des Griffs auf welche Weise betätigt werden (künftig hilfreich zur Optimierung der Ergonomie des Griffs), wie häufig ein Gerät von jeweiligen Nutzern genutzt wird, personalisierte Programm- oder Funktionsvorschläge und dergleichen.

Die Sensorik kann zusätzlich die Erfassung von Nutzerdaten ermöglichen, sodass eine digitale Schnittstelle ausgebildet werden kann, die individuelle Wünsche und Anpassungen des Kunden berücksichtigen und bzw. oder spielerische Ansätze in Kombination mit Nutzerprofilen zulassen kann. Die Datenerfassung kann außerdem vom Hersteller für eine dauerhafte und bzw. oder kundenorientierte sowie feedbackbasierte Optimierung der nachfolgenden Modelle genutzt werden.

Zusätzlich kann es eine digitale Schnittstelle und bzw. oder einen taktilen Slider zur intuitiven Bedienung geben.

Hierdurch kann eine intuitive Bedienung des Geräts ohne zusätzliche Knöpfe o.Ä. ermöglicht werden. Zusätzlich oder alternativ kann eine Nutzenerweiterung des Griffes des Gerätes für den Benutzer erfolgen. Zusätzlich oder alternativ kann eine automatisch anlernende Personalisierung für Nutzer erfolgen. Zusätzlich oder alternativ können - Sicherheitsfunktionen des Geräts umgesetzt werden, beispielsweise dass der Griff eine Kinderhand erkennt und ein Nutzen des Gerätes dann verhindert. Zusätzlich oder alternativ können je nach Ausgangslage des jeweiligen Gerätes mechanische Bedienelemente ersetzt werden. Zusätzlich oder alternativ kann eine Erkennung der Stimmungslage des Nutzers und darauf angepasste Funktionen umgesetzt werden. Zusätzlich oder alternativ kann ein Feeback durch Haptik integrierbar sein. Zusätzlich oder alternativ kann eine Anpassung des Gerätes bzw. von Folgemodellen an Nutzerpräferenzen erfolgen. Zusätzlich oder alternativ kann die Begeisterung des Kunden durch ein innovatives, neues Nutzungserlebnis gesteigert werden.

Zusätzlich oder alternativ liegt der vorliegenden Erfindung die Erkenntnis zugrunde, dass Sicherheitskonzepte üblicherweise auf der Vernunft der Nutzer basieren. Diese zu umgehen ist oft nicht schwierig. Schwere Arbeitsgeräte brauchen viel Haltekraft vom Anwender. Wenn diese Kraft z.B. nach diversen Arbeitsstunden nachlässt, weist das Elektrowerkzeug immer noch seine volle Leistung auf. Durch nicht mehr ausreichendes Festhalten des Geräts durch den Benutzer kann es zum Ausbrechen des Gerätes kommen und zu Schäden am Nutzer oder der Umgebung führen.

Allgemein passen sich Haushaltsgeräte in ihrer Leistung nicht automatisch an die Haltekraft des Nutzers an. Kabelgebundene und akkugetriebene Geräte sind in Stufen einstellbar, aber nicht dynamisch an die Kraft und Leistungsfähigkeit des Nutzers angepasst. Der Energieeinsatz wird nicht personengebunden abgerufen.

Erfindungsgemäß kann daher über die Kraft zur Betätigung eines Griffes einer Person, die ein z.B. Elektrowerkzeug benutzt, die Leistung des Gerätes gesteuert werden. Dies kann zu einer Erhöhung der Arbeitssicherheit der Bediener sowie zu einer effizienten Leistungsauslastung und - Anpassung an die Leistungsfähigkeit des Nutzers führen.

Die Umsetzung kann erfolgen, indem im Griff oder auf der Oberfläche des Griffes eines Elektrogerätes die zupackende Kraft über Sensoren gemessen wird. Je stärker die Hand zugreift, desto mehr Kraft wird aufgenommen. Diese Kraft wird ausgewertet. Die Leistung des Elektrogerätes wird an die gemessene Kraft angepasst.

Beispielsweise kann dies bei einem Bohrhammer umgesetzt werden. Der Bediener ist morgens noch gut ausgeruht und hat genügend Kraft, den Bohrhammer zu halten. Das Gerät arbeitet mit voller Leistung. Richtung Nachmittag, wenn die Muskeln des Bedieners ermüden, wird die Leistung des Bohrhammers selbsttätig reduziert, um nicht bei zu wenig Kraft des Bedieners ihm das Gerät aus der Hand zu schlagen, wenn der Bohrhammer plötzlich klemmt. Das könnte zu Verletzungen oder anderweitigen Schäden führen. Z.B. die Drehmomentrutschkupplung kann über die Sensierung der Handkraft des Bedieners dynamisch eingestellt werden. Der Bohrhammer arbeitet weiter effektiv, vielleicht etwas langsamer, aber sicher für den Bediener.

Beispielsweise kann dies bei einem Staubsauger umgesetzt werden. Der Nutzer fasst den Staubsaugergriff anders an, wenn er über Kork, Fliesen oder andere glatte Flächen gleitet, als wenn er über verschiedene Teppicharten saugt. Hier wird mehr Leistung gebraucht. Der Nutzer packt automatisch kräftiger zu und die Leistung des Staubsaugers wird verstärkt (dynamische Motorregelung). Beispielsweise bei Akkusticks würde sich das positiv auf die Akkuleistung auswirken, wenn nicht immer mit voller Leistung gesaugt wird, sondern z.B. in Abhängigkeit vom Bodenbelag.

Beispielsweise kann dies bei Sportgeräten wie z.B. Crosser oder Rudergerät umgesetzt werden. Abhängig von der Kraft, mit welcher der Bediener die Griffstücke anfasst, könnte die Betätigungskraft der Sportgeräte angepasst werden. Kein Einstellen zu schwerer Stufen, sondern langsam an die Konstitution der Sportler angepasste Trainingseinheiten. Muskeln werden nicht überbeansprucht. Langsamer und sicherer Trainingserfolg.

Beispielsweise kann dies bei einem Kühlschrank umgesetzt werden. Über den Einbau der personalisierenden Sensorik, welche Kraft und Größe der Hand erfasst, in den Kühlschrankgriff könnte gesteuert werden, wer eine Tür öffnen darf. Vielleicht möchte ein Kunde abnehmen und nachts nicht mehr an den Kühlschrank gehen. Dann kann der Kühlschrank nach Betätigen des Griffes ein Signal rausgeben: "Du wolltest nachts nicht mehr an den Kühlschrank gehen". Verbunden mit einer Zeitsteuerung könnte der Zugriff auf Kühlschrankinhalte optimiert werden.

Beispielsweise kann dies bei einer Tür umgesetzt werden. Türgriffe könnten mit der Sensorik ausgestattet werden. Ziel wäre es hier, Kinder vom Öffnen von Türen, die zu gefährlichen Inhalten führen, abzuhalten.

Beispielsweise kann dies bei einem Handrührgerät umgesetzt werden. Über den Griff des Handrührgerätes könnte die Knet- oder Rührkraft sensiert werden. Die Leistung des Gerätes wird angepasst an Teigviskosität und Bedienerkraft. Bei festerem Teig wird automatisch fester zugepackt und die Leistung des Rührgerätes würde verstärkt. Auch könnte die Kraft des Gerätes an nicht so stark zugreifende Kinderhände angepasst werden und die Maschine dem Kind nicht aus der Hand schlagen, wenn die Rührbesen sich verkanten.

Beispielsweise kann dies bei orthopädischen Schuhen oder Einlegesohlen umgesetzt werden. Schuhe können aufgrund einer intelligenten Sohle die Druckbelastung messen und dem Läufer ein Feedback über den Belastungszustand geben. Z.B. nach einer OP, wenn der Fuß bzw. das Bein nicht komplett belastet werden darf, gibt die Sohle eine Info über das Smartphone an den User, ob die Belastung für den Fuß optimal ist, oder er weniger belasten sollte.

Beispielsweise kann dies bei einem Backofengriff umgesetzt werden. Zugriff versperrt für Kinderhände.

In jedem Fall sind die Vorteile dieses Aspekts der vorliegenden Erfindung darin zu sehen, dass Sicherheitskonzepte für elektrische Maschinen zielgerichteter aufgebaut werden und über die Sensorik die Leistung der Geräte beeinflussen können. Sicherheitskonzepte können nicht so schnell gebrückt werden. Technische Geräte passen sich in ihrer Leistung an den User an. Leistungsanpassung an Kraftanpassung kann u.U. zu Energieeinsparung und längeren Laufzeiten für Akkus führen. Medizinische Produkte bzw. Orthesen können Feedback zur Belastung / zum Druck geben.

Mehrere Ausführungsbeispiele der Erfindung sind in den Zeichnungen rein schematisch dargestellt und werden nachfolgend näher beschrieben. Es zeigt
- Figur 1: eine perspektivische Darstellung eines erfindungsgemäßen Elektrogeräts gemäß einem ersten Ausführungsbeispiel in Form eines Kühlschranks von vorne;
- Figur 2: eine Darstellung eines erfindungsgemäßen Elektrogeräts gemäß einem zweiten Ausführungsbeispiel in Form eines Ofens von vorne; und
- Figur 3: ein Ablaufdiagramm eines erfindungsgemäßen Verfahrens.

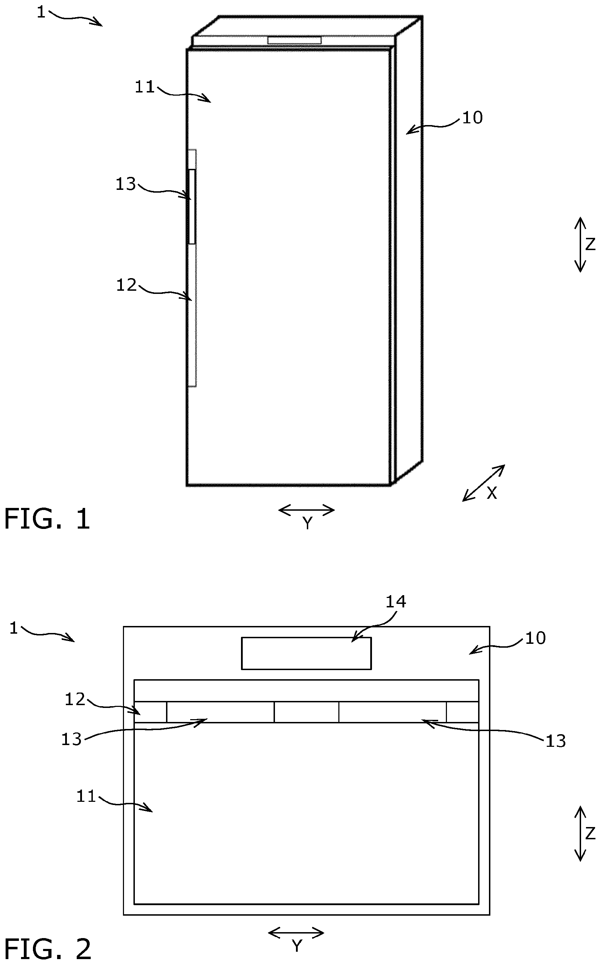

Die Figuren 1 und 2 werden in kartesischen Koordinaten betrachtet. Es erstreckt sich eine Längsrichtung X, welche auch als Tiefe X oder als Länge X bezeichnet werden kann. Senkrecht zur Längsrichtung X erstreckt sich eine Querrichtung Y, welche auch als Breite Y bezeichnet werden kann. Senkrecht sowohl zur Längsrichtung X als auch zur Querrichtung Y erstreckt sich eine vertikale Richtung Z, welche auch als Höhe Z bezeichnet werden kann und der Richtung der Schwerkraft entspricht. Die Längsrichtung X und die Querrichtung Y bilden gemeinsam die Horizontale X, Y, welche auch als horizontale Ebene X, Y bezeichnet werden kann.

Ein erfindungsgemäßes Elektrogerät 1 wird am Beispiel von zwei Haushaltsgeräten 1 bzw. Küchengeräten 1 in Form eines Kühlschranks 1, siehe Figur 1, sowie eines Ofens 1, siehe Figur 2, betrachtet.

Der Kühlschrank 1 der Figur 1 weist ein Gehäuse 10 auf, welches einen Innenraum (nicht dargestellt) des Kühlschrank 1 im Wesentlichen von unten, von oben, von hinten und von beiden Seiten umgibt bzw. umschließt. Der Innenraum kann mittels eines Verschlusselements 11 in Form einer Tür 11 verschlossen sowie zugänglich gemacht werden. Um dabei die Tür 11 gegenüber dem Gehäuse 10 öffnen und schließen bzw. schwenken zu können, weist die Tür 11 ein Griffelement 12 in Form eines Griffs 12 auf, welcher in der vertikalen Richtung Z länglich ausgebildet und in der Querrichtung Y an der linken Kante der Tür 11 angeordnet ist, wobei die Tür 11 an ihrer rechten Kante schwenkbar mit dem Gehäuse 10 verbunden ist.

Erfindungsgemäß sind entlang des Griffs 12 taktile Sensoren 13 am Griffelement 12 derartig angeordnet, dass die Art des Greifens einer Person als Benutzer von dem Kühlschrank 1 bzw. dessen Steuerungseinheit (nicht dargestellt) sensorisch erfasst und weiterverarbeitet werden kann. Die Art des Greifens des Griffs 12 durch den Benutzer kann hinsichtlich der Position des Greifens, hinsichtlich der Bewegung bzw. des Bewegungsablaufs des Greifens, hinsichtlich der Größe der Fläche des Greifens, hinsichtlich der Kontur der Fläche des Greifens, hinsichtlich der Kraft des Greifens und bzw. oder hinsichtlich der Kraftänderung des Greifens ausgewertet werden.

Auf diese Art und Weise kann die Art des Greifens des Benutzers vom Kühlschrank 1 als Bedienung bzw. als Eingabe verwendet werden, ohne dass der Benutzer zusätzliche bzw. separate Bedienungen bzw. Eingaben vornehmen muss. Dies kann die Nutzungsmöglichkeiten des Kühlschranks 1 für den Benutzer erweitern.

Auch kann der Benutzer durch die Art seines Greifens identifiziert oder zumindest von anderen Personen unterschieden werden. Dies kann eine personalisierte Bedienung bzw. Nutzung des Kühlschranks 1 für mehrere Personen ermöglichen.

Dies kann vergleichbar bei dem Ofen 1 des zweiten Ausführungsbeispiels der Figur 2 umgesetzt werden, welcher als Verschlusselement 11 eine nach unten herunterklappbare Klappe 11 aufweist. Ferner sind an der Frontseite einer Blende (nicht bezeichnet) des Gehäuses 10 des Ofens 1 Anzeige-/Bedienelemente vorgesehen. Die taktilen Sensoren 13 sind an zwei in der Querrichtung Y seitlich zueinander beabstandeten Bereichen des horizontal verlaufenden Griffs 12 angeordnet.

In diesem Fall können als Sicherheitsfunktion beispielsweise durch die Art des Greifens Kinder von Erwachsenen unterschieden werden, um lediglich Erwachsenen das Öffnen der Klappe 11 zu ermöglichen. Hierzu kann ein betätigbares Riegel (nicht dargestellt) vorgesehen sein, welcher die geschlossene Klappe 11 sperren kann, falls durch die Art des Greifens ein Kind erkannt wird. Hierdurch kann verhindert werden, dass ein Kind mit der Hitze des Innenraums des Ofens 1 in Kontakt kommen kann, wenn der Ofen 1 betrieben wird.

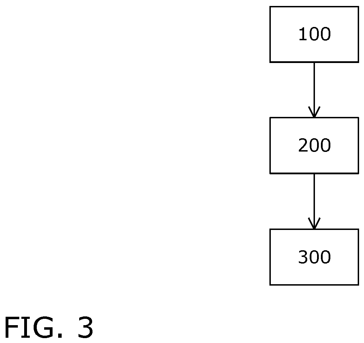

In jedem Fall kann ein erfindungsgemäßes Verfahren gemäß der Figur 3 derart ablaufen, dass in einem ersten Schritt ein Erfassen 100 des Greifens des Griffelements 12 durch den Benutzer mittels des taktilen Sensors 13 erfolgt und die sensorisch erfassten Daten der Steuerungseinheit des Küchengeräts 1 zur Verfügung gestellt werden. In einem zweiten Schritt kann ein Bestimmen 200 der Art des Greifens des Griffelements 12 durch den Benutzer seitens der Steuerungseinheit erfolgen, wie zuvor beschrieben. In Reaktion hierauf kann in einem dritten Schritt ein Betreiben 300 des Elektrogeräts 1 in Abhängigkeit der Art des Greifens des Griffelements 12 durch den Benutzer erfolgen bzw. eben nicht, beispielsweise als Sicherheitsfunktion wie zuvor beschrieben.

### Bezugszeichenliste (Bestandteil der Beschreibung)

- X: Längsrichtung; Tiefe; Länge
- Y: Querrichtung; Breite
- Z: vertikale Richtung; Höhe
- X, Y: Horizontale; horizontale Ebene

- 1: Elektrogerät; Haushaltsgerät; Küchengerät; Kühlschrank; Ofen
- 10: Gehäuse
- 11: Verschlusselement; Tür; Klappe
- 12: Griffelement; Griff
- 13: taktile Sensoren der Griffelemente 12
- 14: Anzeige-/Bedienelemente

- 100: Erfassen des Greifens des Griffelements 12 durch den Benutzer
- 200: Bestimmen der Art des Greifens des Griffelements 12 durch den Benutzer
- 300: Betreiben des Elektrogeräts 1 in Abhängigkeit der Art des Greifens des Griffelements 12 durch den Benutzer oder nicht.

## Patentansprüche

1. Elektrogerät (1), vorzugsweise Haushaltsgerät (1),
mit wenigstens einem Griffelement (12), welches ausgebildet ist, zum Gebrauch des Elektrogeräts (1) von einem Benutzer mit zumindest einer Hand gegriffen zu werden,
wobei das Griffelement (12) wenigstens einen taktilen Sensor (13) aufweist, welcher ausgebildet ist, ein Greifen des Griffelements (12) durch den Benutzer zu erfassen,
**dadurch gekennzeichnet, dass**
das Elektrogerät (1), vorzugweise eine Steuerungseinheit des Elektrogeräts (1), ausgebildet ist,
• die Art des Greifens des Griffelements (12) durch den Benutzer zu bestimmen und
• das Elektrogerät (1) in Abhängigkeit der Art des Greifens des Griffelements (12) durch den Benutzer zu betreiben oder nicht zu betreiben.

2. Elektrogerät (1) nach Anspruch 1,
wobei die Art des Greifens des Griffelements (12) durch den Benutzer umfasst:
• eine Position des Greifens des Griffelements (12) durch den Benutzer entlang des taktilen Sensors (13) in wenigstens einer Richtung, vorzugsweise in zwei Richtungen,
• eine Bewegung des Greifens des Griffelements (12) durch den Benutzer entlang des taktilen Sensors (13) in wenigstens einer Richtung, vorzugsweise in zwei Richtungen,
• eine Größe der Fläche des Greifens des Griffelements (12) durch den Benutzer entlang des taktilen Sensors (13) in wenigstens einer Richtung, vorzugsweise in zwei Richtungen,
• eine Kontur der Fläche des Greifens des Griffelements (12) durch den Benutzer entlang des taktilen Sensors (13) in wenigstens einer Richtung, vorzugsweise in zwei Richtungen,
• eine Kraft des Greifens des Griffelements (12) durch den Benutzer senkrecht zum taktilen Sensor (13) und/oder
• eine Kraftänderung des Greifens des Griffelements (12) durch den Benutzer senkrecht zum taktilen Sensor (13).

3. Elektrogerät (1) nach Anspruch 1 oder 2,
wobei das Elektrogerät (1), vorzugweise dessen Steuerungseinheit, ausgebildet ist, den Benutzer aufgrund der bestimmten Art seines Greifens des Griffelements (12) zu erkennen,
wobei das Elektrogerät (1), vorzugweise dessen Steuerungseinheit, ferner ausgebildet ist, wenigstens eine Funktion in Abhängigkeit des erkannten Benutzers auszuführen oder nicht auszuführen.

4. Elektrogerät (1) nach einem der vorangehenden Ansprüche,
wobei das Elektrogerät (1), vorzugweise dessen Steuerungseinheit, ausgebildet ist, eine Stimmung des Benutzers aufgrund der Art seines Greifens des Griffelements (12) zu erkennen,
wobei das Elektrogerät (1), vorzugweise dessen Steuerungseinheit, ferner ausgebildet ist, wenigstens eine Funktion in Abhängigkeit der erkannten Stimmung des Benutzers auszuführen oder nicht auszuführen.

5. Elektrogerät (1) nach einem der vorangehenden Ansprüche,
wobei das Elektrogerät (1), vorzugweise dessen Steuerungseinheit, ausgebildet ist, wenigstens eine Funktion in Abhängigkeit der bestimmten Art seines Greifens des Griffelements (12), vorzugsweise in Abhängigkeit des erkannten Benutzers, freizugeben oder zu sperren.

6. Elektrogerät (1) nach einem der vorangehenden Ansprüche,
wobei der taktile Sensor (13) flächig auf dem Griffelement (12) ausgebildet ist.

7. Elektrogerät (1) nach einem der vorangehenden Ansprüche,
wobei der taktile Sensor (13) eine Mehrzahl von flächig angeordneten einzelnen Sensorelementen aufweist.

8. Elektrogerät (1) nach einem der vorangehenden Ansprüche,
wobei der taktile Sensor (13) resistiv oder kapazitiv erfassend ausgebildet ist.

9. Elektrogerät (1) nach einem der vorangehenden Ansprüche,
wobei der taktile Sensor (13) flexibel, vorzugsweise mittels eines flexiblen Trägers, ausgebildet ist.

10. Verfahren zum Betreiben eines Elektrogeräts (1), vorzugsweise Haushaltsgerät (1),
wobei das Elektrogerät (1) wenigstens ein Griffelement (12) aufweist, welches ausgebildet ist, zum Gebrauch des Elektrogeräts (1) von einem Benutzer mit zumindest einer Hand gegriffen zu werden,
wobei das Griffelement (12) wenigstens einen taktilen Sensor (13) aufweist, welcher ausgebildet ist, ein Greifen des Griffelements (12) durch den Benutzer zu erfassen,
mit wenigstens den Schritten:
• Erfassen (100) des Greifens des Griffelements (12) durch den Benutzer,
• Bestimmen (200) der Art des Greifens des Griffelements (12) durch den Benutzer und
• Betreiben (300) des Elektrogeräts (1) in Abhängigkeit der Art des Greifens des Griffelements (12) durch den Benutzer oder nicht.
